# EUROPEAN PATENT APPLICATION

(11) **EP 2 197 035 A2**
(43) Date of publication of application: **16.06.2010**
(21) Application number: 09177061.0
(22) Date of filing: 25.11.2009
(51) Int. Cl.: H01L 31/0224, H01L 31/068, H01L 31/18

(54) **Solar Cell with Co-Planar Backside Metallization**

(30) Priority: 09.12.2008 US 331284
(71) Applicant: Palo Alto Research Center Incorporated, Palo Alto, California 94304 (US)
(72) Inventor: Nakayashiki, Kenta, 1338, Sandvika (NO); Fork, David K., Los Altos, CA 94024 (US); Solberg, Scott E., Los Altos, CA 94023 (US)
(74) Representative: Gervasi, Gemma

(57) **Abstract**

A solar cell includes two backside metallization materials that are simultaneously extrusion deposited on a semiconductor substrate such that both a back surface field (BSF) metal layer (e.g., Al) and a solder pad metal structure (e.g., AgAl) are coplanar and non-overlapping, and the two metals abut each other to form a continuous metal layer that extends over the backside surface of the substrate. In one embodiment, the solder pad metal is formed directly on the backside surface of the substrate, either by co-extruding the two materials in the form of a continuous sheet, or by depositing spaced apart structures that are then flattened to contact each other by way of an air jet device. In another embodiment, the solder pad metal is disposed over a thin layer of the BSF metal (i.e., either disposed directly on the BSF metal, or disposed on an intervening barrier layer) using a co-extrusion head.

## Description

### FIELD OF THE INVENTION

The present invention is related to the production of solar cells, and more particularly to the production of backside metallization on H-pattern solar cells.

### BACKGROUND

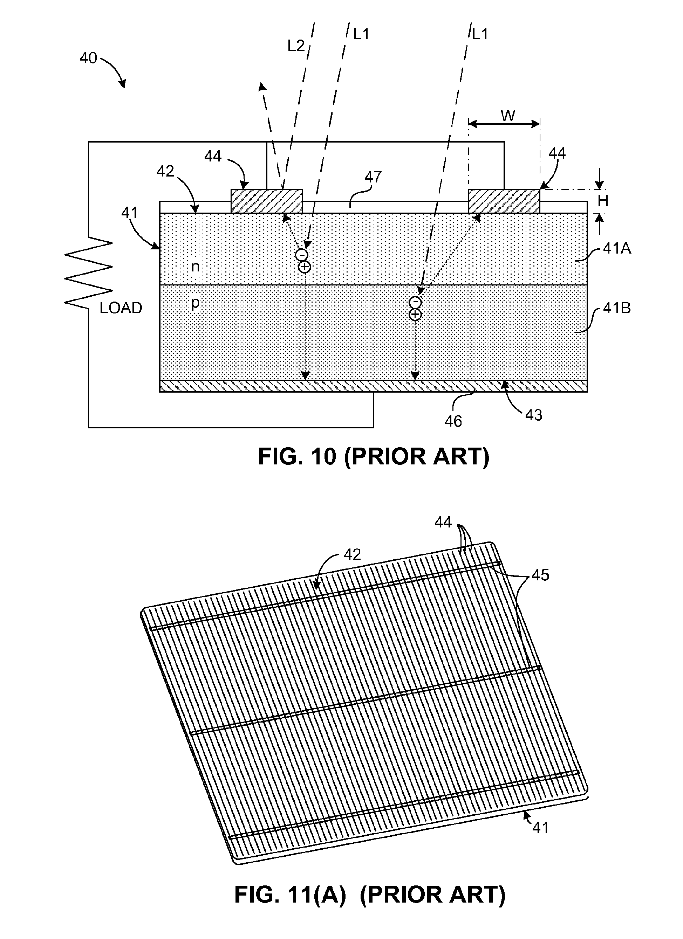

Fig. 10 is a simplified diagram showing an exemplary conventional H-pattern contact solar cell 40 that converts sunlight into electricity by the inner photoelectric effect. Solar cell 40 is formed on a semiconductor (e.g., multi-crystalline silicon) substrate 41 that is processed using known techniques to include an n-type doped upper region 41A and a p-type doped lower region 41B such that a pn-junction is formed in the substrate 41. Disposed on a frontside surface 42 of semiconductor substrate 41 are a series of parallel metal gridlines (fingers) 44 (shown in end view) that are electrically connected to n-type region 41A. A substantially solid conductive layer 46 is formed on a backside surface 43 of substrate 41, and is electrically connected to p-type region 41B. An antireflection coating 47 is typically formed over upper surface 42 of substrate 41. Solar cell 40 generates electricity when a photon from sunlight beams L1 pass through upper surface 42 into substrate 41 and hit a semiconductor material atom with an energy greater than the semiconductor band gap, which excites an electron ("-") in the valence band to the conduction band, allowing the electron and an associated hole ("+") to flow within substrate 41. The pn-junction separating n-type region 41A and p-type region 41B serves to prevent recombination of the excited electrons with the holes, thereby generating a potential difference that can be applied to a load by way of gridlines 44 and conductive layer 46, as indicated in Fig. 10.

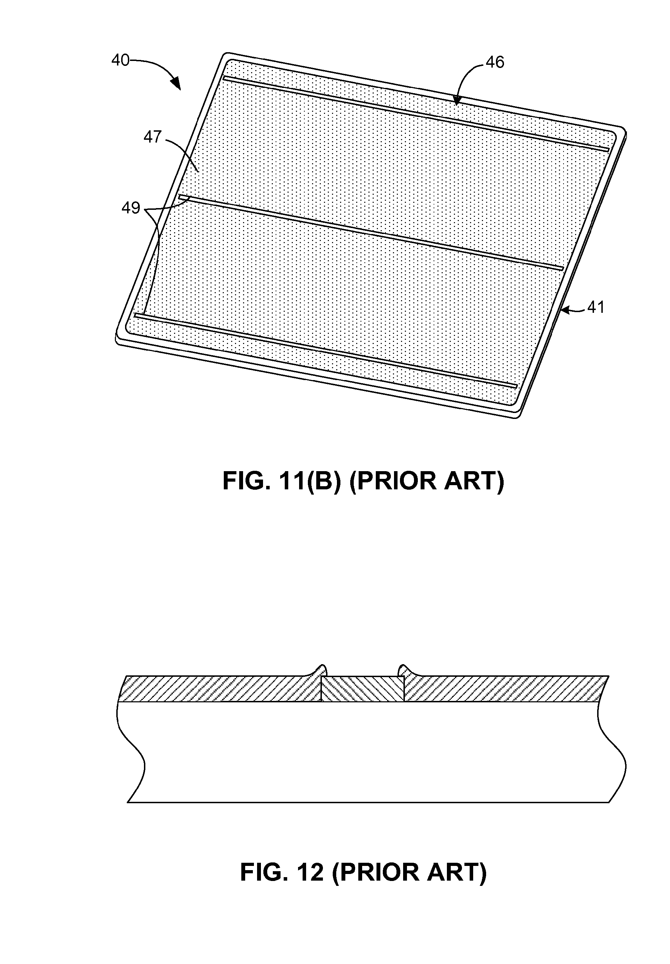

Figs. 11(A) and 11(B) are perspective views showing the frontside and backside contact patterns, respectively, of solar cell 40 in additional detail. As shown in Fig. 11(A), the frontside contact pattern solar cell 40 consists of a rectilinear array of parallel narrow gridlines 44 and one or more wider collection lines (bus bars) 45 that extend perpendicular to gridlines 44, both disposed on upper surface 42. Gridlines 44 collect electrons (current) from substrate 41 as described above, and bus bars 45 which gather current from gridlines 44. In a photovoltaic module, bus bars 45 become the points to which metal ribbon (not shown) is attached, typically by soldering, with the ribbon being used to electrically connect one cell to another. As shown in Fig. 11(B), the backside contact pattern solar cell 40 consists of a substantially continuous back surface field (BSF) metallization layer 46 and two spaced apart solder pad metallization structures 48 that are disposed on backside surface 43. Similar to bus bars 45 formed on upper surface 42, solder pad metallization structures 48 serve as points to which metal ribbon (not shown) is soldered, with the ribbon being used to electrically connect one cell to another.

Conventional methods for producing solar cell 40 includes screen-printing conductor inks onto silicon substrate 41 in three separate printing steps: (1) silver (Ag) for gridlines 44 and bus bars 45 on frontside surface 42, (2) silver-aluminum (AgAl) for solder pad metallization structures on backside (rear) surface 43, (3) and Al for BSF metallization on backside surface 43. In order to form both soldering pad and BSF metallization layers on backside surface 43, first AgAl ink is screen printed and dried at 100-200°C, then Al ink is screen printed and dried.

Fig. 12 is a simplified partial cross-sectional view showing an exemplary solder pad metallization structure 48 and an exemplary BSF metallization layer 46 formed on backside surface 43 of substrate 41 after the printing process described above is completed (frontside structures are omitted for brevity). As a result of the two-step successive print method, the Al ink used to form BSF metallization layer 46 is printed such that it overlaps with the AgAl solder pad metallization structure 48. This overlap is essential in order to ensure that the two metallizations come into contact with each other within the alignment registration tolerances of the successive screens. Typically, the registration of one screen to the next is about 100 microns, so overlapping sections 46-1 and 46-2 having widths on the order of 100 microns are necessarily formed on corresponding edge portions 48-1 and 48-2 of solder pad metallization structure 48 in order to avoid gaps in the electrical contact.

The two-stage screen printing backside metallization structure depicted in Fig. 12 produces several problems that increase production costs. First, the resulting overlap arrangement produces a non-planar topography (i.e., due to the ridges produced by BSF overlapping sections 46-1 and 46-2), which makes holding substrate 41 by way of a vacuum chuck (not shown) more difficult, which in turn increases costs during module assembly. In addition, in many solar cell production lines, it is common to loose about 0.5% of the wafers (substrates) on each separate handling step. The rear metallization step accounts for two such handling operations (i.e., one for each screen printing process); therefore, the yield loss is on the order of 1% for printing alone. It is of course desirable to minimize the handling to as few process steps as possible in order to maximize yield as well as to reduce processing time, labor and floor space costs. Third, the overlap arrangement requires an excess quantity of AgAl, namely edge portions 48-1 and 48-2 of solder pad metallization structure 48 that are covered by Al BSF metallization. Because they are covered by Al, edge portions 48-1 and 48-2 are unavailable for soldering the metal ribbon, yet they add to the materials cost of solar cell 40. Further, everywhere on solar cell 40 where AgAl is present (i.e., instead of Al) current is lost due to recombination because Al generates a back surface field that repels minority carriers, but the AgAl does not.

What is needed is a method for forming backside metallization on a solar cell that avoids the problems mentioned above in association with the conventional two-stage screen printing production process.

### SUMMARY OF THE INVENTION

The present invention is directed to various solar cells and associated production methods in which backside metallization is extrusion deposited onto the backside surface of a semiconductor substrate (e.g., crystalline silicon wafer) such that upper surfaces of the back surface field (BSF) metal (e.g., Al) and the solder pad metal (e.g., AgAl) are coplanar and non-overlapping, and the two metals abut each other to form a continuous metal layer that extends over the backside surface of the substrate. In one embodiment, the solder pad metal (e.g., AgAl) extends from the planar upper surface to the backside surface of the substrate (i.e., the solder pad and BSF metals have a common thickness). In another embodiment, the solder pad metal (e.g., AgAl) is disposed over a thin layer of the BSF metal (i.e., either disposed directly on the BSF metal, or disposed on an intervening barrier layer). In both embodiments, the present invention provides a planar surface that facilitates easier handling of the solar cell (e.g., using a vacuum chuck) when compared to solar cells produced by conventional overlapping methods (described above). In addition, the present invention facilitates reduction in the amount of costly solder pad metal (i.e., Ag) by avoiding the need to overlap the solder pad metal with the BSF metal, thereby maximizing the exposed surface of the solder pad metal for soldering to metal ribbon in the production of solar cell panels, while minimizing the amount of solder pad metal that contacts the substrate surface, thereby increasing the solar cell efficiency through a reduction in surface recombination velocity.

In accordance with a first series of embodiments, solar cells having the desired characteristics of the present invention are produced by simultaneously depositing both the BSF metal and the solder pad metal onto the backside surface of the solar cell substrate. By simultaneously depositing the BSF and solder pad metals, the present invention reduces overall manufacturing costs by minimizing handling to as few process steps as possible in order to maximize yield, as well as to reduce processing time and complexity, which serves to reduce equipment, labor and floor space costs. In one specific embodiment, a novel printhead device is utilized in which Al and Ag inks are laterally coextruded in a continuous sheet across the entire substrate backside surface in a single pass. In another embodiment, parallel, spaced apart beads of Al and Ag inks are printed on the substrate backside surface, and then an airjet mechanism is used to flatten (slump) the beads such that they merge and form a continuous sheet. The disclosed methods reduce solar cell process steps and time by depositing both inks simultaneously, and increase production yields through decreased wafer handling.

In accordance with a second series of embodiments, solar cells having the desired characteristics of the present invention are produced by depositing the BSF metal (e.g., A1) as a continuous sheet on the backside surface of the solar cell substrate, and depositing the solder pad metal (e.g., AgAl) onto thinned portions of the BSF metal. With this approach the carrier recombination velocity at the backside surface would be reduced because of the presence of the Al-BSF below the AgAl metal pad (i.e., nearly 100% rear surface would be covered with Al-BSF, which improves the back surface recombination velocity and cell performance over prior art methods in which sections of the surface are contacted by the AgAl solder pad metal pads). In one embodiment, the AgAl-on-Al structure is achieved by first forming a vertical bi-material laminar flow of AgAl or pure Ag ink on top of Al ink within the printhead, and then merging this flow together with a lateral laminar flow of Al ink (i.e., the inks are simultaneously co-extruded). A potential problem with this embodiment is the diffusion of Al into the solder pad region, which, if it occurs to a sufficient extent, will render the pad unsolderable since Al is not a solderable metal. An embodiment which remedies this problem is to introduce a barrier layer between the AgAl and Al inks during the co-extrusion process.

### BRIEF DESCRIPTION OF THE DRAWINGS

These and other features, aspects and advantages of the present invention will become better understood with regard to the following description, appended claims, and accompanying drawings, where:

Fig. 1 is a perspective view showing the backside metallization of a solar cell produced in accordance with a generalized embodiment of the present invention;

Fig. 2 is a front view showing a micro-extrusion system including a co-extrusion printhead assembly utilized in accordance with another embodiment of the present invention;

Fig. 3 is a simplified side view showing a portion of the micro-extrusion system of Fig. 2 during operation;

Fig. 4 is an exploded perspective view showing a co-extrusion printhead assembly utilized in conjunction with the micro-extrusion system of Fig. 2 in accordance with a specific embodiment of the present invention;

Fig. 5 is a simplified diagram showing a layered nozzle layer of the co-extrusion printhead assembly of Fig. 4;

Fig. 6 is a cross-sectional end view of an exemplary backside metallization layer formed by the co-extrusion printhead assembly of Fig. 4;

Fig. 7 is a side view showing a portion of a micro-extrusion system according to another embodiment of the present invention;

Fig. 8 is a simplified perspective top view depicting the formation of backside metallization utilizing the micro-extrusion system of Fig. 7;

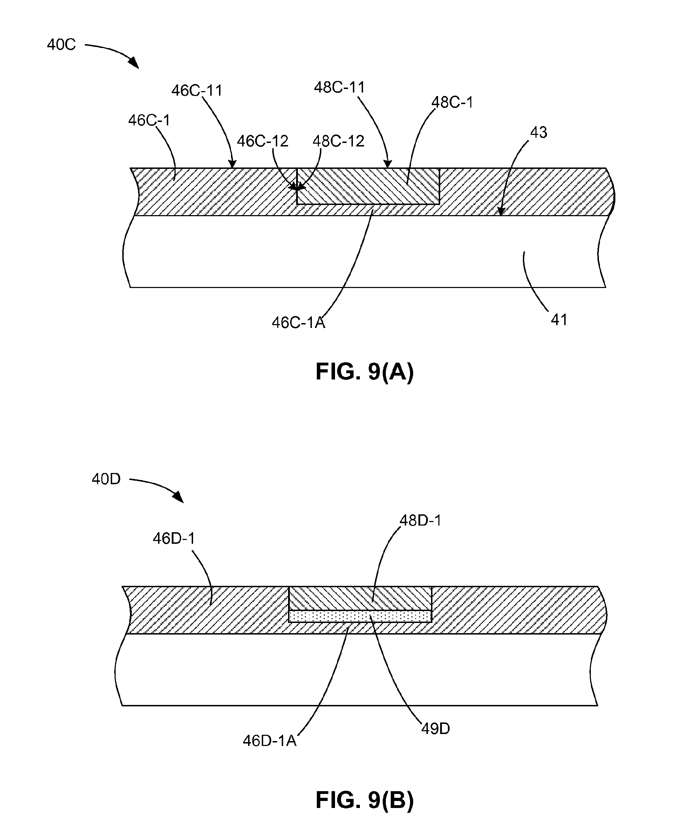

Figs. 9(A) and 9(B) are cross-sectional end views showing exemplary backside metallization layers formed in accordance with alternative embodiments of the present invention;

Fig. 10 is a simplified cross-sectional side view showing a conventional solar cell;

Figs. 11(A) and 11(B) are top and bottom perspective views, respectively, showing a conventional H-pattern solar cell;

Fig. 12 is a simplified cross-sectional side view showing backside metallization structures associated with the conventional H-pattern solar cell of Figs. 11(A) and 11(B).

### DETAILED DESCRIPTION

The present invention relates to an improvement in micro-extrusion systems. The following description is presented to enable one of ordinary skill in the art to make and use the invention as provided in the context of a particular application and its requirements. As used herein, directional terms such as "upper", "top", "lower", "bottom", "front", "rear", and "lateral" are intended to provide relative positions for purposes of description, and are not intended to designate an absolute frame of reference. Various modifications to the preferred embodiment will be apparent to those with skill in the art, and the general principles defined herein may be applied to other embodiments. Therefore, the present invention is not intended to be limited to the particular embodiments shown and described, but is to be accorded the widest scope consistent with the principles and novel features herein disclosed.

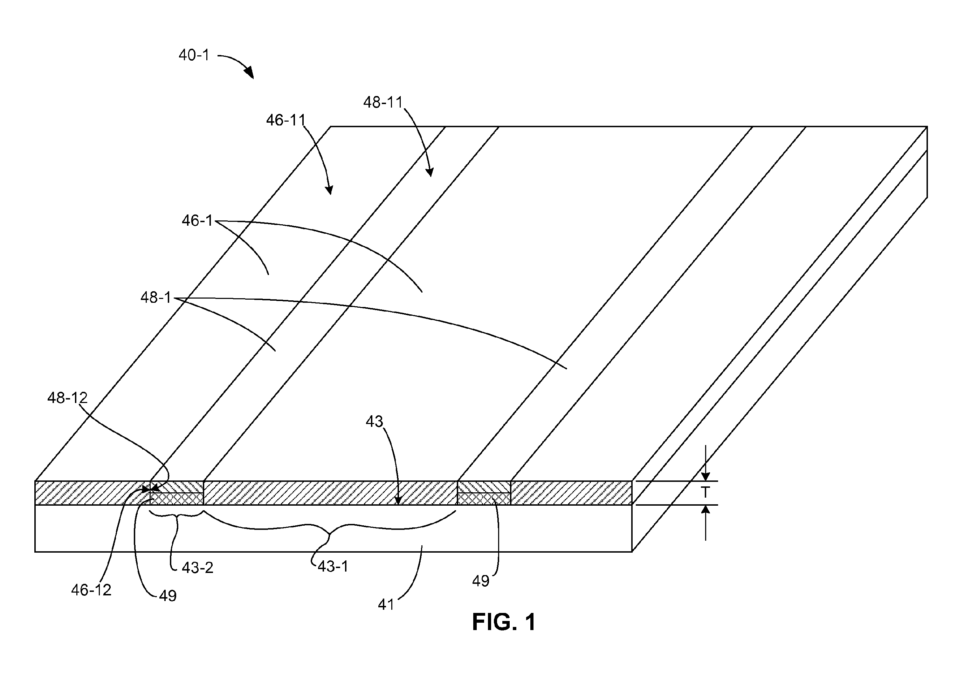

Fig. 1 is a simplified cross-sectional side view showing the backside metallization of a solar cell 40-1 that is formed in accordance with a generalized embodiment of the present invention. Note that, in accordance with the generalized embodiment, the frontside metallization (not shown) of solar cell 40-1 is similar to that show and described with reference to Fig. 10(A). The backside metallization is formed on the backside surface 43 of a semiconductor substrate (e.g., a monocrystalline silicon wafer) 41, and includes a back surface field (BSF) metallization layer 46-1 and a pair of solder pad metallization layers 48-1. BSF metallization layer 46-1 is a continuous sheet of metal (e.g., Al) that is formed over a corresponding (first) portion 43-1 of backside surface 43, and has a substantially planar upper surface (first surface portion) 46-11 facing away from backside surface 43. BSF metallization layer 46-1 includes edge portions 46-12 at each interface with solder pad metallization layers 48-1, where each edge portion 46-12 extends from the planar first surface portion 46-11 toward backside surface 43 (i.e., edge portions 46-12 form a substantially 90° angle relative to surface 46-11 and backside surface 43). Solder pad metallization layers 48-1 are elongated structures disposed over corresponding (second) portions 43-2 of the backside surface 43, with each solder pad metallization layer 48-1 having corresponding planar (second) surface portions 48-11 that face away from the backside surface 43, and peripheral (second) edge portions 48-12 extending between surface portions 48-11 and backside surface 43.

In accordance with an aspect of the present invention, the upper surfaces of BSF metallization layer 46-1 and solder pad metallization layer 48-1 cooperatively define a substantially planar, continuous sheet over substantially all of backside surface 43. That is, BSF metallization layer 46-1 and solder pad metallization layer 48-1 are disposed such that each BSF edge portion 46-12 abuts a corresponding edge portion 48-12 of solder pad metallization layer 48-1 in a non-overlapping manner, whereby each planar first surface portion 46-11 adjacent each interface (i.e., where each edge portion 46-12 abuts a corresponding edge portion 48-12) is substantially coplanar with the adjacent planar surface portion 48-11 of the associated solder pad metallization layer 48-1. By forming BSF metallization layers 46-1 and solder pad metallization layers 48-1 in the non-overlapping manner depicted in Fig. 1, the present invention provides a backside metallization structure having a planar surface that facilitates easier handling of the solar cell (e.g., using a vacuum chuck) when compared to solar cells produced by conventional overlapping methods (described above). In addition, by eliminating the overlapped section of solder pad metal (e.g., sections xxx, described above with reference to Fig. 11), the present invention facilitates a reduction in the amount of costly solder pad metal (i.e., Ag), and maximizes the amount of exposed surface portion 48-11 of the solder pad metal that is available for soldering to metal ribbon in the production of solar cell panels, while minimizing the amount of solder pad metal that contacts backside surface 43, thereby increasing the efficiency of solar cell 40-1 through a reduction in surface recombination velocity.

As depicted in Fig. 1 and discussed in additional detail below with reference to various alternative embodiments of the present invention, each solder pad metallization layer 48-1 is disposed on zero or more optional layers 49 (i.e., when present, one or more optional layers 49 are disposed between solder pad metallization layer 48-1 and backside surface 43). For example, in accordance with one embodiment described below, optional layer 49 include solder pad metallization (i.e., optional layer 49 is part of solder pad metallization layer 48-1, which extends from its upper surface 48-11 to backside surface 43 such that solder pad metallization layer 48-1 and BSF metallization layer 46-1 have a common thickness T), and in another embodiment, optional layer 49 is embodied by a thin layer of BSF metal (e.g., Al) that is disposed between solder pad metallization layer 48-1 and backside surface 43. In yet another embodiment described below, optional layer 49 is embodied by a thin layer of the BSF metal and an intervening barrier layer disposed between the BSF metal and solder pad metallization layer 48-1. The benefits of each of these embodiments are described below.

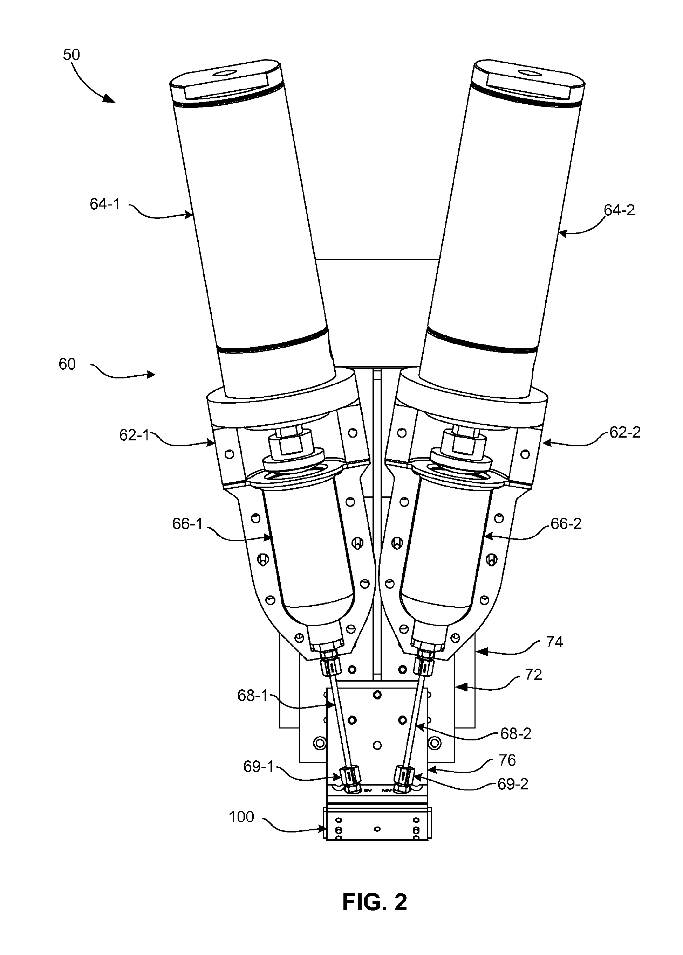

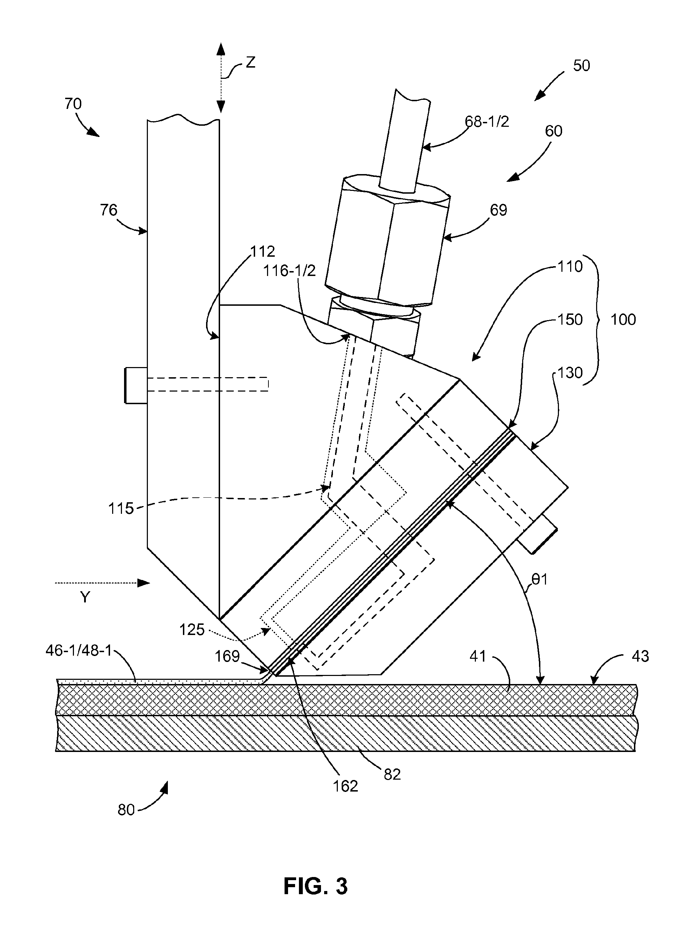

Figs. 2 and 3 illustrate a generalized co-extrusion system 50 utilized in accordance with alternative embodiment of the present invention. Co-extrusion system 50 includes a material feed system 60 for supplying two extrusion materials (i.e., inks containing the solder pad and BSF metallization described herein) to a printhead assembly 100, and printhead assembly 100 includes mechanisms and features for co-extruding the two extrusion materials in the manner set forth in detail below.

Referring to Fig. 2, material feed system 60 represents exemplary experimental arrangement utilized to produce solar cells on a small scale, and those skilled in the art will recognize that other arrangements would typically be used to produce solar cells on a larger scale. Referring to the upper portion of Fig. 2, material feed system 60 includes a pair of housings 62-1 and 62-2 that respectively support pneumatic cylinders 64-1 and 64-2, which is operably coupled to cartridges 66-1 and 66-2 such that material forced from these cartridges respectively passes through feedpipes 68-1 and 68-2 into printhead assembly 100. As indicated in the lower portion of Fig. 2, micro-extrusion system 50 further includes a Z-axis positioning mechanism (partially shown) including a Z-axis stage 72 that is movable in the Z-axis (vertical) direction by way of a housing/actuator 74 (partially shown) using known techniques. A mounting plate 76 is rigidly connected to a lower end of Z-axis stage 72 and supports printhead assembly 100, and a mounting frame (not shown) is rigidly connected to and extends upward from Z-axis stage 72 and supports pneumatic cylinders 64-1 and 64-2 and cartridges 66-1 and 66-2.

Fig. 3 is a side view showing a generalized portion of a micro-extrusion system 50 for extruding BSF and solder pad metallization layers 46-1 and 48-1 on backside surface 43 of substrate 41 to form BSF metallization layer 46-1 and solder pad metallization layer 48-1. Printhead assembly 100 is operably coupled to material feed system 60 by way of feedpipes 68-1/2 (described above) and associated fasteners 69. The extruded materials (inks) are applied through pushing and/or drawing techniques (e.g., hot and cold) in which the materials are pushed (e.g., squeezed, etc.) and/or drawn (e.g., via a vacuum, etc.) through extrusion printhead assembly 100, and out one or more outlet orifices (exit ports) 169 that are respectively defined in a lower portion of printhead assembly 100. Mounting plate 76 of X-Y-Z-axis positioning mechanism 70 rigidly supports and positions printhead assembly 100 relative to substrate 41, and a base 80 is provided that includes a platform 82 for supporting substrate 41 in a stationary position as printhead assembly 100 is moved in a predetermined (e.g., Y-axis) direction over substrate 41. In alternative embodiment (not shown), printhead assembly 100 is stationary and base 80 includes an X-Y axis positioning mechanism for moving substrate 41 under printhead assembly 100.

As shown in Fig. 3, printhead assembly 100 includes a back plate structure 110, a front plate structure 130, and a layered nozzle structure 150 connected therebetween. Back plate structure 110 and front plate structure 130 serve to guide the BSF and solder pad extrusion materials from inlet ports 116-1 and 116-2 to layered nozzle structure 150 by way of flow channels 115 and 125, respectively, and into layered nozzle structure 150 such that extruded material traveling down extrusion nozzle 163 is directed toward substrate 41 at a predetermined tilted angle θ1 (e.g., 45°).

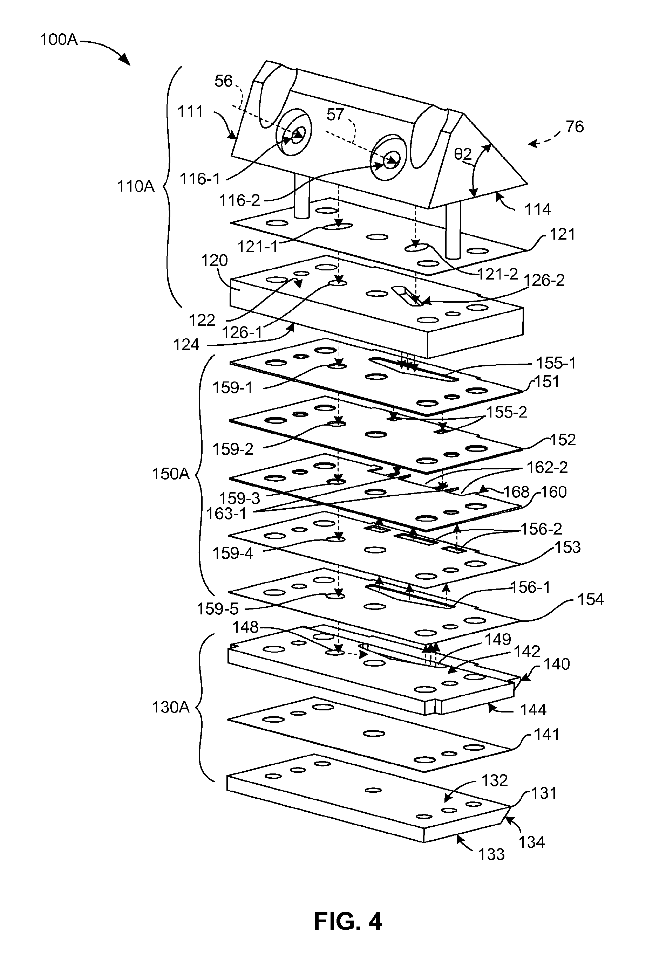

Fig. 4 is an exploded perspective view showing a micro-extrusion printhead 100A according to a specific embodiment of the present invention. Micro-extrusion printhead 100A includes a back plate structure 110A, a front plate structure 130A, and a layered nozzle structure 150A connected therebetween. Back plate structure 110A and front plate structure 130A serve to guide the extrusion material from corresponding inlet ports 116-1 and 116-2 to layered nozzle structure 150A, and to rigidly support layered nozzle structure 150A such that extrusion nozzles 162-1 and 162-2 defined in layered nozzle structure 150E are pointed toward substrate 51 at a predetermined tilted angle (e.g., 45°), whereby extruded material traveling down each extrusion nozzle 162-1 and 162-2 toward its corresponding nozzle orifice 169 is directed toward target substrate 51.

Referring to the upper portion of Fig. 4, back plate structure 110a includes a molded or machined metal (e.g., aluminum) angled back plate 111, a back plenum 120, and a back gasket 121 disposed therebetween. Angled back plate 111 defines a pair of bores (not shown) that respectively extend from threaded countersunk bore inlets 116-1 and 116-2 to corresponding bore outlets defined in lower surface 114. Back plenum 120 includes parallel front surface 122 and back surface 124, and defines a pair of conduits (not shown) extending from corresponding inlets 126-1 and 126-2 defined through front surface 122 to corresponding outlets (not shown) defined in back surface 124. Similar to the description provided above, the bores/conduits defined through back plate structure 110A feed extrusion material to layered nozzle structure 150.

Referring to the lower portion of Fig. 4, front plate structure 130A includes a molded or machined metal (e.g., aluminum) front plate 131, a front plenum 140, and a front gasket 141 disposed therebetween. Front plate 131 includes a front surface 132, a side surface 133, and a beveled back surface 134, with front surface 132 and back surface 134 forming a predetermined angle. Front plate 131 defines several holes for attaching to other sections of printhead assembly 100A, but does not channel extrusion material. Front plenum 140 includes parallel front surface 142 and back surface 144, and defines a conduit (not shown) extending from corresponding inlet 148 to a corresponding outlet 149, both being defined through front surface 142. As described below, the conduit defined in front plenum 140 serves to feed BSF (Al) metallization ink to layered nozzle structure 150A.

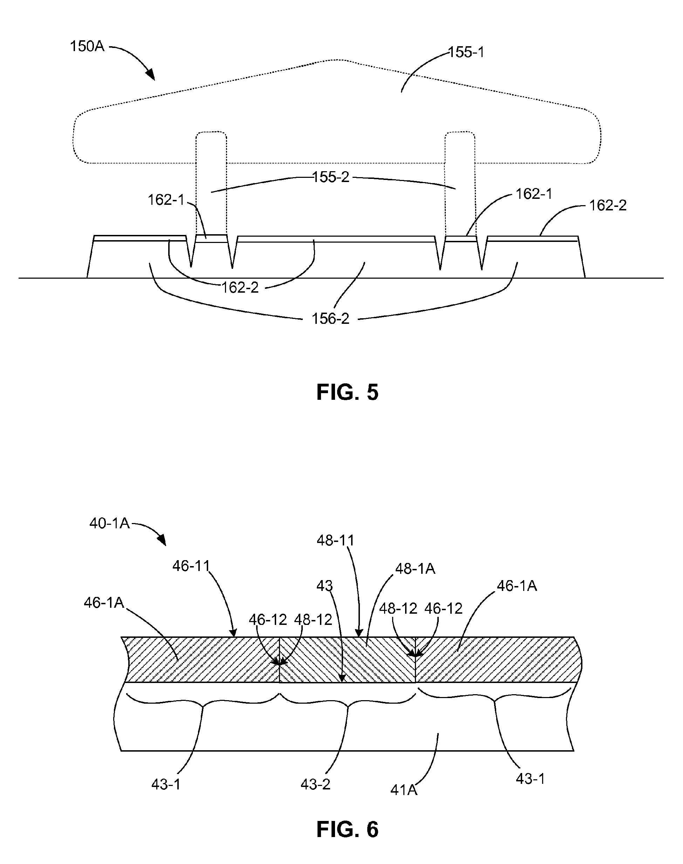

As depicted in Fig. 4 and diagrammatically illustrated in Fig. 5, layered nozzle structure 150A includes a top feed layer 151, a top nozzle plate 152, a bottom nozzle plate 153, a bottom feed layer 154, and a nozzle outlet plate 160 that is sandwiched between top nozzle plate 152 and bottom nozzle plate 153. Top feed layer 151 includes an elongated top plenum opening 155-1 that feeds solder pad material to two channels 155-2 that are defined in top nozzle plate 152, which in turn feeds the solder pad material to relatively narrow nozzles 162-1, which direct the material through corresponding slit openings defined through front edge 168 of nozzle outlet plate 160. Note that triangular dividers 167 disposed between the slit openings extend toward but not up to the end of each slit orifice, thereby allowing the two different inks to abut in the desired fashion as they exit printhead assembly 100A. As indicted by the dashed-line arrows in Fig. 4, BSF material is fed through a series of openings 126-1, 159-1, 159-2, 159-3, 159-4, 159-5 and 148 into front plenum 140, which redirects the material through outlet 149 into bottom plenum opening 156-1 defined in bottom feed layer 154, and into bottom feed channels 156-2 that pass the BSF material into nozzles 162-2, which direct the material through corresponding slit openings defined through front edge 168 of nozzle outlet plate 160. Note that printhead assembly 100A is a laminar flow co-extrusion printing device that deposits both Al and Ag ink in a continuous sheet of metallization ink with abruptly changing material composition. Continuous metallization is essential in order to collect the base current of the solar cell from the entire area of the cell and to convey it to the soldered ribbon metallization that conveys the current from the cell and into the solar panel or module.

Fig. 6 shows a portion of a solar cell 40-1A depicting a backside metallization structure formed by printhead assembly 100A on a silicon substrate 41A. In accordance with a specific embodiment, both Al ink and AgAl ink are simultaneously deposited directly onto respective surface portions 43-1 and 43-2 of backside surface 43 of silicon wafer 41 in a continuous sheet to form BSF material layers 46-1A and solder pad metallization layers 48-1A, respectively, wherein the AgAl and the Al metallizations form a common edge (i.e., opposing side edges 48-12 of solder pad metallization layer 46-1 abut corresponding side edges 48-12 of solder pad metallization layers 48-1). Upper surfaces 46-11 and 48-11 of BSF material layers 46-1A and solder pad metallization layers 48-1A face away from backside surface 43, and side edges 46-12 and 48-12 extend between upper surfaces 46-11 and 48-11 and backside surface 43. In this structure the carrier recombination velocity at backside surface 43 is reduced relative to conventional overlapping screen printed structures (described above) because the AgAl contact area is minimized (i.e., the overlapped portions present in the conventional structure are omitted). The Al ink is melted into silicon upon firing to form aluminum back surface field (Al-BSF) metallization for reducing the carrier recombination velocity over a larger wafer area because the required width of the AgAl trace is reduced by the area of the overlap region that is eliminated. There is also a cost reduction associated with this structure because the quantity of expensive Ag is reduced.

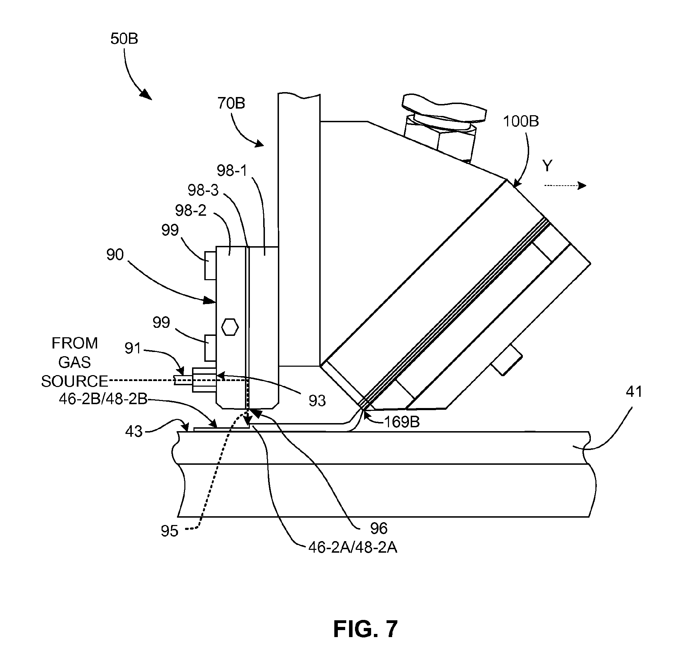

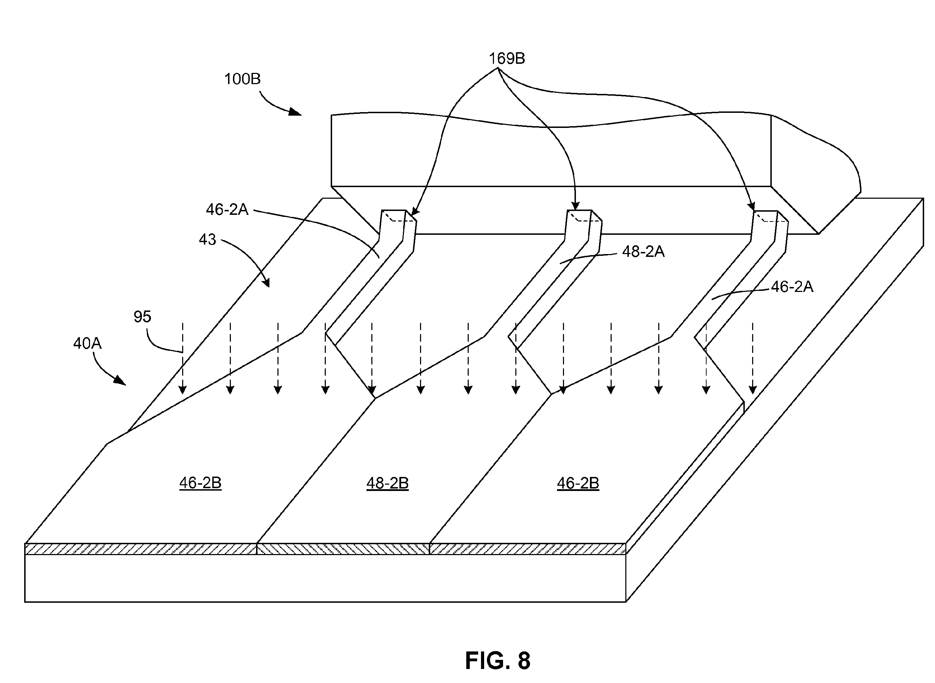

Figs. 7 and 8 are partial side and simplified partial perspective views, respectively, showing a portion of a micro-extrusion system 50B according to another embodiment of the present invention. As indicated in Fig. 7, micro-extrusion system 50B includes a Z-axis positioning mechanism 70B and printhead assembly 100B and other features similar to those described above, but differs in that nozzles 169B of printhead assembly 100B are separated to deposit the extruded material as spaced apart beads 46B-2A and 48B-2A (i.e., as described below with reference to Fig. 8), and system 50B also includes a gas jet array 90 that is mounted onto Z-axis positioning mechanism 70B such that gas jet array 90 directs pressurized gas (e.g., air, dry nitrogen, or other gas phase fluid) 95 downward onto extruded beads 46B-2A and 48B-2A immediately after they have contacted backside surface 43 of target substrate 41 (i.e., while the extruded material is still "wet"). Gas jet array 90 includes clamp portions 98-1 and 98-2 disposed on opposite sides of one or more metal air jet plates 98-3, and are secured to Z-axis positioning mechanism 70B by way of screws 99. As indicated, back clamp portion 98-2 includes a threaded inlet 93 that receives pressurized gas by way of a pipe 91. The pressurized gas passes through a channel (not shown) that communicates with one or more elongated nozzle outlets 96. As illustrated in Fig. 8, directing pressurized gas 95 downward onto beads 46B-2A and 48B-2A causes the beads to flatten and flow together, thereby forming a continuous sheet of material on backside surface 43 having a cross-section similar to that described above with reference to Fig. 6. That is, pressurized gas 95 applies sufficient force to flatten (slump) beads 46B-2A and 48B-2A toward substrate surface 43, thereby facilitating the formation of wide and flat structures using relatively narrow and tall extrusion nozzles. With this technique, a single bead can be expanded to many times its deposited width. For example, with this arrangement, the inventors have found it possible to flatten (slump) extruded material lines from a width of about 0.4 mm to a width of greater than 2 mm and a wet thickness of 0.010 to 0.020 mm. With the loading and viscosity of the ink used for extrusion printing it would be impossible to produce lines of these dimensions directly, even by allowing large amounts of time for the ink to slump under gravitational and wetting forces.

Note that the approach discussed with reference to Figs. 7 and 8 would not work with conventional (i.e., relatively highly thixotropic) inks intended for screen printing, but works well with inks that are modified to be easily flowing, such as those disclosed in co-owned and co-pending U.S. Patent Application No. 12/273,113 (Atty Docket No. 20080173-US-NP) entitled "EASILY FLOWING INKS FOR EXTRUSION THROUGH SMALL CROSS-SECTION CHANNELS/DIES/NOZZLES", filed Nov. 18, 2008. Further, by separating the Al ink into a number of smaller beads, the amount of ink deposited on backside surface 43 is reduced, which in turn reduces the fired Al thickness, thereby reducing stress which causes wafer warping. In a preferred embodiment the nozzles have a height of 50 microns or more to avoid excessive clogging. It is further desirable to utilize inks for backside metallization that have low metal-particle loading to reduce the fired thickness, and in the case of Ag, to reduce manufacturing costs. If only gravity and surface tension forces are employed, the slumping and joining of closely-spaced lines take approximately 10-30 seconds (depending on the degree of completion of the merge), which is not a problem because the backside printing is done in a single step and the printed wafers are subject to such delays anyway as the wafers travel sequentially down the conveyor from the printer to the dryer and a wafer buffer can be used if necessary. As described above, gas-jets can greatly speed the slumping process and reduce the need to buffer wafers.

Although the present invention has been described with respect to certain specific embodiments, it will be clear to those skilled in the art that the inventive features of the present invention are applicable to other embodiments as well, all of which are intended to fall within the scope of the present invention. For example, the present invention can be applicable to the fabrication of interdigitated back contact cells by depositing two different kinds of doping inks and/or electrodes to form n- and p-doped regions and metal contacts. In addition, the formation of the BSF metallization using an Al ink and the solder contact metallization using an AgAl ink is meant for illustrative purposes. Other metals and alloys could be used to form these structures without falling outside the intent and scope of this invention. In a separate embodiment, the printhead can be constructed with separate slit orifices for the Al and Ag inks, and these orifices can be slightly overlapping. This structure would produce a nearly identical overlapped structure to the screen printed structure shown to illustrate the prior art in Fig. 12. The bead of ink may be directed toward the substrate by employing the directional control structures described in co-owned and co-pending U.S. Patent Application No. 12/267,069 entitled "DIRECTIONAL EXTRUDED BEAD CONTROL", filed Nov. 7, 2008, and co-owned and co-pending U.S. Patent Application No. 12/267,223 entitled "MICRO-EXTRUSION SYSTEM WITH BEAD DEFLECTING MECHANISM", filed Nov. 7, 2008. Other metals beside Ag can be used. For example, Cu may also be soldered and may be suitable with an appropriate barrier metal, such as nickel.

## Claims

1. A solar cell comprising:
a semiconductor substrate having a backside surface;
a back surface field metallization layer substantially covering a continuous area of
said backside surface; and
a solder pad metallization layer embedded within said back surface field
metallization layer such that the back surface field metallization layer and the solder pad
metallization layer have surfaces substantially in the same plane.

2. The solar cell of Claim 1, wherein the solder pad metallization layer and said back surface field metallization layer share a common edge.

3. The solar cell of Claim 1, wherein:
• the back surface field metallization layer comprises Al; or
• the solder pad metallization layer comprises at least one of Ag and Al.

4. The solar cell of claim 1, wherein the back surface field metallization layer is disposed on a first portion of the backside surface, the back surface field metallization layer having a planar first surface portion facing away from the backside surface, and a first edge portion extending from the planar first surface portion toward the backside surface;
the solder pad metallization layer is disposed over a second portion of the backside surface, the solder pad metallization layer having a planar second surface portion facing away from the backside surface, and a second edge portion extending from the planar first surface portion toward the backside surface; and
the back surface field metallization layer and the solder pad metallization layer are disposed such that the first edge portion of the back surface field metallization layer abuts the second edge portion of the solder pad metallization layer in a non-overlapping manner such that the planar first surface portion is substantially coplanar with the planar second surface portion.

5. The solar cell of Claim 4, wherein the back surface field metallization layer consists essentially of Al.

6. The solar cell of Claim 4, wherein the solder pad metallization layer comprises Ag.

7. The solar cell of Claim 4, wherein the back surface field metallization layer consists essentially of Al, and the solder pad metallization layer consists essentially of AgAl.

8. The solar cell of Claim 4, wherein said solder pad metallization layer contacts the backside surface of the semiconductor substrate.

9. The solar cell of Claim 4, wherein a portion of said back surface field metallization layer is disposed between said solder pad metallization layer and said backside surface; preferably
a barrier layer is disposed between said portion of said back surface field metallization layer and said solder pad metallization layer.

10. A method for fabricating a backside metallization structure on a semiconductor substrate comprising:
moving a printhead having at least one nozzle orifice relative to the semiconductor substrate; and
feeding an Al passivation layer ink and an AgAl soldering pad ink through said printhead such that both said Al passivation layer ink and said AgAl soldering pad ink are simultaneously extruded from said at least one nozzle orifice and deposited onto the semiconductor substrate.

11. The method of Claim 10, wherein feeding said Al passivation layer ink and said AgAl soldering pad ink comprises:
causing said Al passivation layer ink and said AgAl soldering pad ink to exhibit laminar flow in said at least one nozzle orifice prior to exiting said printhead; or
merging said Al passivation layer ink and said AgAl soldering pad ink prior to exiting from a common slit orifice defined in said printhead.

12. The method of Claim 10, wherein feeding said Al passivation layer ink and said AgAl soldering pad ink comprises causing said Al passivation layer ink and said AgAl soldering pad ink prior to exit from separate spaced-apart orifices defined in said printhead such that said Al passivation layer ink forms a first bead on said substrate and said AgAl soldering pad ink forms a second bead on said substrate, and the method further comprises flattening said first and second beads using a gas jet.

13. The method of Claim 10, wherein feeding said Al passivation layer ink and said AgAl soldering pad ink comprises causing portions of said Al passivation layer ink to overlap corresponding portions of said AgAl soldering pad ink.

14. The method of Claim 10, further comprising feeding a barrier material through said printhead such that both said barrier material is disposed between a portion of said Al passivation layer ink and said AgAl soldering pad ink when said Al passivation layer ink and said AgAl soldering pad ink are simultaneously extruded from said at least one nozzle orifice and deposited onto the semiconductor substrate.
